(19) **Europäisches Patentamt**

**European Patent Office**

**Office européen des brevets**

(11) **EP 0 823 982 B1**

(12) **FASCICULE DE BREVET EUROPEEN**

(45) Date de publication et mention
de la délivrance du brevet:
**13.12.2000 Bulletin 2000/50**

(51) Int Cl.⁷: **H01S 5/40**

(86) Numéro de dépôt international:
**PCT/FR97/00373**

(21) Numéro de dépôt: **97907163.6**

(22) Date de dépôt: **03.03.1997**

(87) Numéro de publication internationale:
**WO 97/33353 (12.09.1997 Gazette 1997/39)**

(54) **AMPLIFICATEUR OPTIQUE A SEMI-CONDUCTEUR**

**OPTISCHER HALBLEITERVERSTÄRKER**

**SEMICONDUCTOR OPTICAL AMPLIFIER**

(84) Etats contractants désignés:
**DE ES FR GB IT NL SE**

(30) Priorité: **05.03.1996 FR 9602748**

(43) Date de publication de la demande:
**18.02.1998 Bulletin 1998/08**

(73) Titulaire: **ALCATEL**
**75008 Paris (FR)**

(72) Inventeurs:
• **EMERY, Jean-Yves**
**F-91120 Palaiseau (FR)**
• **GOLDSTEIN, Léon**
**F-91370 Chaville (FR)**
• **DOUSSIERE, Pierre**
**F-91180 Saint-Germain-lès-Arpajon (FR)**
• **BARRAU, Jean**
**F-31290 Gardouch (FR)**

(74) Mandataire: **Fournier, Michel Robert Marie et al**
**COMPAGNIE FINANCIERE ALCATEL**
**Département Propriété Industrielle**
**30, avenue Kléber**
**75116 Paris (FR)**

(56) Documents cités:
**EP-A- 0 469 681          EP-A- 0 525 779**
**EP-A- 0 615 323**

• JOURNAL OF LIGHTWAVE TECHNOLOGY, vol. 8, no. 3, Mars 1990, NEW YORK US, pages 302-308, XP000141876 A.G. FAILLA ET AL.: "STRUCTURAL DESIGN CRITERIA FOR POLARIZATION INSENSITIVE SEMICONDUCTOR OPTICAL AMPLIFIERS"
• ELECTRONICS LETTERS, vol. 27, no. 11, 23 Mai 1991, STEVENAGE GB, pages 899-900, XP000232423 G. GLASTRE ET AL.: "POLARISATION INSENSITIVE 1.55 MICROMETER SEMICONDUCTOR INTEGRATED OPTICAL AMPLIFIER WITH ACCESS WAVEGUIDES GROWN BY LP-MOCVD"
• IEEE PHOTONICS TECHNOLOGY LETTERS, vol. 5, no. 4, Avril 1993, NEW YORK US, pages 406-408, XP000368317 M.A. NEWKIRK ET AL.: "1.5 MICROMETER MULTIQUANTUM-WELL SEMICONDUCTOR OPTICAL AMPLIFIER WITH TENSILE AND COMPRESSIVELY STRAINED WELLS FOR POLARIZATION-INDEPENDENT GAIN" cité dans la demande
• IEEE PHOTONICS TECHNOLOGY LETTERS, vol. 6, no. 2, Février 1994, NEW YORK US, pages 170-172, XP000439743 P. DOUSSIERE ET AL.: "1.55 MICROMETER POLARISATION INDEPENDENT SEMICONDUCTOR OPTICAL AMPLIFIER WITH 25 DB FIBER TO FIBER GAIN" cité dans la demande
• IEEE JOURNAL OF QUANTUM ELECTRONICS, vol. 30, no. 3, Mars 1994, NEW YORK US, pages 695-702, XP000450554 K. MAGARI ET AL.: "POLARIZATION-INSENSITIVE OPTICAL AMPLIFIER WITH TENSILE-STRAINED-BARRIER MQW STRUCTURE"

**Description**

La présente invention concerne l'amplification de signaux optiques. Elle trouve typiquement application dans les réseaux de télécommunications à fibres optiques. Les signaux transmis par ces réseaux sont constitués d'impulsions portant sous forme binaire une information à transmettre. Ces impulsions doivent être amplifiées pour compenser des pertes de puissance qu'elles subissent au cours de leur propagation dans ces réseaux. Les amplificateurs à semi-conducteurs constituent un moyen peu encombrant et intégrable pour réaliser cette amplification. Cependant, en l'absence de dispositions particulières, leur gain est sensible à l'état de polarisation de la lumière qu'ils reçoivent, ce qui sera plus simplement indiqué ci-après en mentionnant la sensibilité d'un amplificateur à la polarisation. Cette invention trouve alors plus particulièrement application dans le cas où il convient de supprimer ou du moins de limiter cette sensibilité. Ce cas est fréquent. Il apparait lorsque, d'une part la distance parcourue par des impulsions optiques à amplifier est telle que l'état de polarisation de ces impulsions a été affecté d'une manière importante et aléatoire au cours de leur propagation et lorsque, d'autre part il est préférable que les impulsions amplifiées présentent un ou plusieurs niveaux de puissance prédéterminés.

De manière plus générale cette invention trouve application chaque fois que la sensibilité d'un amplificateur optique à la polarisation doit être nulle ou limitée.

On sait qu'un amplificateur optique à semi-conducteur comporte une plaquette constituée de couches de matériaux semi-conducteurs ayant des indices de réfraction respectifs et formant un réseau cristallin commun. En l'absence de contraintes mécaniques, des réseaux formés respectivement par ces matériaux ont des dimensions caractéristiques constituant des mailles respectives de ces matériaux. Ces couches se succèdent selon une direction verticale formant un trièdre trirectangle avec deux directions horizontales constituant une direction longitudinale et une direction transversale , ces directions étant définies par rapport à cette plaquette. Cette dernière comporte au moins les couches ou groupes de couches ou partie de couche suivants:

- Un substrat constitué majoritairement d'un matériau de base semi-conducteur ayant un premier type de conductivité. Ce substrat présente une épaisseur suffisante pour imposer les dimensions de la maille du matériau de base à tout le réseau cristallin de la plaquette.
- Une couche active incluant un matériau actif apte à amplifier une lumière par recombinaison stimulée de porteurs de charges des deux types injectés dans ce matériau.
- Une structure guidante. Cette structure comporte au moins un ruban présentant un indice de réfraction plus grand que celui de matériaux environnants. Elle s'étend selon la direction longitudinale pour guider ladite lumière selon cette direction. Ce ruban présente une largeur et une épaisseur respectivement transversale et verticale.
- Enfin une couche de confinement supérieure (18) constituée d'un matériau ayant un deuxième type de conductivité opposé au premier.

Cet amplificateur comporte en outre une électrode inférieure et une électrode supérieure respectivement formées sur la face inférieure et la face supérieure de la plaquette pour permettre de faire passer entre ces faces un courant électrique injectant lesdits porteurs de charge des deux types dans le matériau actif.

Les matériaux de base des amplificateurs optiques à semi-conducteurs connus sont du type III-V. Ce sont typiquement le phosphure d'indium et l'arséniure de gallium. Leur matériau actif est typiquement un matériau ternaire ou quaternaire constitué avec les mêmes éléments chimiques. Il est généralement souhaité que la largeur du ruban qui guide la lumière soit voisine d'un micromètre pour faciliter la formation de ce ruban par gravure et surtout pour faciliter l'intégration de l'amplificateur avec d'autres composants optiques sur une même plaquette semi-conductrice. L'épaisseur doit alors être très inférieure à cette largeur pour assurer un guidage mononodal de la lumière dont la longueur d'onde est typiquement 1310 ou 1550 nm. En l'absence de dispositions particulières c'est cette forme rectangulaire de la section du ruban qui tend à entrainer la sensibilité à la polarisation précédemment mentionnée.

Diverses familles de tels amplificateurs connus se distinguent les unes des autres par les diverses dispositions qui y sont prises pour rendre ces amplificateurs insensibles à la polarisation.

Une première famille d'amplificateurs connus comporte un ruban du type dit "ridge" c'est à dire érigé en saillie sur la plaquette semi-conductrice. Compte tenu du fait que les deux faces latérales d'un tel ruban le séparent d'un milieu gazeux tel que l'air dont l'indice de réfraction est très inférieur à celui du matériau semi-conducteur, un ajustement de la hauteur du ruban permet de donner à la section de ce ruban une forme qui, tout en étant fortement rectangulaire, peut laisser l'amplificateur insensible à la polarisation. Un amplificateur de cette première famille est décrit notamment dans un article :

S.Pajarola, J.Eckner, P.A.Besse, G.Guekos and D. Syvridis, "Temperature behaviour of a bulk lnGaAsP/lnP ridge waveguide structure for polarisation insensitive optical amplifier operation", Appl. Physics Lett.65, No. 22, pp. 2762-2764, 1994.

Les amplificateurs de cette première famille présentent notamment l'inconvénient que l'ajustement nécessaire de la hauteur du ruban peut être difficile à réaliser. On peut aussi noter que la chaleur dégagée en service dans le matériau actif est difficilement évacuée en raison de la faible conductivité thermique du milieu gazeux qui entoure le ruban et dont le matériau actif est nécessairement proche.

Un tel ajustement de hauteur de ruban n'est par contre pas nécessaire dans une deuxième et troisième familles d'amplificateurs connus qui sont dits "à ruban enterré". Dans ces amplificateurs le matériau actif constitue le ruban guidant la lumière et il est entouré de toutes parts par un matériau semi-conducteur binaire. Ce dernier présente l'avantage de bien conduire la chaleur mais son indice de réfraction n'est que légèrement inférieur à celui du matériau actif.

Dans ladite deuxième famille d'amplificateurs connus la couche active est du type dit "à puits quantiques". Ceci s'oppose au cas où le matériau actif est homogène et est alors dit massique (bulk material). Dans cette deuxième familles la section du ruban enterré est fortement rectangulaire. Compte tenu de la faible différence d'indice entre ce ruban et le matériau binaire environnant, le confinement d'une onde à polarisation horizontale est supérieur à celui d'une onde à polarisation verticale, la différence entre ces deux confinements étant d'autant plus grande que le rapport de la largeur à l'épaisseur du ruban est grand. Le confinement mentionné ici à propos d'une onde est considéré dans un plan transversal. Il est égal au rapport de la puissance de cette onde transitant dans l'aire occupée par le ruban à la puissance totale de cette onde. Le confinement est défini pour chaque polarisation et pour chaque longueur d'onde par la forme et les dimensions de la section du ruban et par les indices de réfraction du matériau de ce ruban et du matériau environnant. Dans le cas d'une section de ruban rectangulaire il peut être considéré comme étant le produit d'un confinement directionnel selon la direction horizontale par un confinement directionnel selon la direction verticale, chacun de ces deux confinements directionnels dépendant de la polarisation. Compte tenu du fait que le phénomène d'amplification de l'onde par recombinaison de porteurs et émission stimulée n'est réalisé que dans le matériau actif, c'est à dire dans le ruban, le gain de l'amplificateur pour une onde est d'autant plus grand que le confinement de cette onde est plus grand. Il en résulte que, si le matériau du ruban était un matériau homogène, et de plus isotrope, donc insensible à la polarisation, le gain de l'amplificateur serait plus grand pour les ondes à polarisation horizontale et que pour celles à polarisation verticale.

C'est pourquoi, dans les amplificateurs connus de cette deuxième famille, le matériau du ruban n'est ni homogène, ni isotrope. Il est tout d'abord non homogène, c'est à dire composite, parce qu'il présente la forme d'une structure constituée par une succession, selon la direction verticale, de couches constituant alternativement des puits quantiques et des barrières. Les puits quantiques sont constitués du matériau actif et ont des épaisseurs de l'ordre de 8nm. Les barrières sont constituées du matériau de base et ont des épaisseurs de l'ordre de 10nm. Cette structure à puits quantiques est à distinguer d'autres structures qui sont constituées également de couches successives mais dans lesquelles les épaisseurs des couches sont beaucoup plus grandes, par exemple 50nm. Un matériau homogène ou constitué de telles couches épaisses étant dit "massif" ou, internationalement, "bulk material",

Le matériau du ruban n'est pas isotrope parce que la maille du matériau actif est inférieure à celle du matériau de base. Les puits quantiques sont donc soumis à une contrainte de tension bidirectionnelle dans le plan horizontal. Cette contrainte a pour effet de rendre un gain gV du matériau actif pour les ondes à polarisation verticale plus grand qu'un gain correspondant gH pour les ondes à polarisation horizontale, ces gains étant des gains linéiques, c'est à dire par unité de longueur. La différence entre ces deux gains croit avec cette contrainte. Or le gain linéique effectif de l'amplificateur GH ou GV pour une onde à polarisation horizontale ou verticale est le produit du confinement CH ou CV de cette onde par le gain gH ou gV du matériau du ruban pour cette onde, respectivement. Le choix d'une contrainte convenable du matériau actif permet alors de réaliser l'égalité :

$$CH.gH = CV.gV$$

c'est à dire GH = GV,
c'est à dire d'obtenir l'insensibilité de l'amplificateur à la polarisation.

Les amplificateurs de cette deuxième famille présentent notamment l'inconvénient d'une mauvaise position spectrale c'est à dire que les longueurs d'ondes des lumières susceptibles d'être amplifiées efficacement par les rubans à puits quantiques contraints sont mal adaptées à leur transmission à grande distance par fibres optiques lorsque les contraintes appliquées à ces puits sont suffisantes pour rendre ces amplificateurs insensibles à la polarisation. Des amplificateurs de cette deuxième famille ont été décrits notamment dans les articles :

"1.5 µm Multiquantum-Well Semiconductor Optical Amplifier with Tensile and Compressively Strained Wells for Polarization-independent Gain" M.A. Newkirk, B.I. Miller, U. Koren, M.G. Young, M. Chien, R.M. Jopson, and C.A. Burrus.
IEEE PHOTONICS TECHNOLOGY LETTERS, VOL.4, NO 4, APRIL 1993 et,
"Polarization insensitive multiple quantum well laser amplifiers for the 1300nm window" L.F. Tiemeijer, P. A. Thijs, T. van Dongen, R. W. M. Slootweg, J. M. M. van der Heijden, J. J. M. Binsma, and M. P. C. M. Krijn,
Appl. Phys. Lett. 62 (8), 22 February 1993.

De manière connue l'application d'une contrainte de tension à un matériau actif favorise le gain gV de ce matériau pour les ondes à polarisation verticales aussi bien lorsque ce matériau est mis en oeuvre sous la forme massive que lorsqu'il l'est sous celle de puits quantiques. C'est pourquoi, il a été considéré que cet effet d'une telle contrainte pouvait peut être permettre d'obtenir l'insensibilité d'un amplificateur à la polarisation avec un matériau actif massique. Une disposition éventuellement utile a été proposée dans ce but. Avant de décrire cette disposition il convient de préciser les difficultés qui apparaissent lorsqu'on veut utiliser une telle contrainte dans ce but. Une telle difficulté est que la contrainte peut favoriser une démixion, c'est à dire une ségrégation des composants d'un matériau quaternaire. La difficulté la plus importante est cependant liée à l'existence inévitable de dislocations dans le réseau cristallin du matériau semi-conducteur. Elle tient au fait que toute contrainte de tension appliquée à un tel matériau tend à provoquer la propagation et l'amplification des dislocations de son réseau cristallin. De telles dislocations nuisent notamment au rendement énergétique de l'amplificateur et peuvent même le rendre inutilisable. Il est connu que, pour chaque valeur de la contrainte et pour chaque matériau, il existe une épaisseur de couche, dite "épaisseur critique", au delà de laquelle les amorces de dislocation se propagent d'une manière telle que le matériau devient inutilisable. L'existence de cette épaisseur critique est notamment décrite dans l'article :
"Defects in epitaxial multilayers" J. W. Matthews and A. E. Blakeslee, J. Crystal Growth 27, 118 (1974).

Cette difficulté liée aux dislocations n'a pas empêché la réalisation des amplificateurs connus de la deuxième famille ci-dessus parce que les épaisseurs des puits quantiques sont sensiblement inférieures aux épaisseurs critiques correspondant aux contraintes appliquées. C'est pourquoi, pour le cas où des épaisseurs de couches de matériaux actifs devraient dépasser celles des puits quantiques, et être par exemple supérieures à 30 nm, la disposition éventuellement utile mentionnée ci-dessus consisterait à séparer de telles couches par des couches d'un autre matériau semi-conducteur auquel serait appliquée une contrainte de compression qui réaliserait en moyenne, une compensation des contraintes. Mais cette disposition éventuellement utile n'est pas apparue en pratique comme pouvant surmonter utilement la difficulté liée aux dislocations. Cette disposition théorique est notamment décrite dans :
"1.55-μm Polarization-Insensitive Optical Amplifier with Strain-Balanced Superlattice Active Layer" A. Godefroy, A. Le Corre, F. Clérot, S. Salaün, S. Loualiche, J. C. Simon, L. Henry, C. Vaudry, J. C. Kéromnès, G. Joulié, and P. Mamouler,
IEEE PHOTONICS TECHNOLOGY LETTERS, VOL. 7, NO 5 MAY 1995

Les inconvénients des amplificateurs connus de la deuxième famille et les difficultés connues qui seraient liées à l'emploi de la disposition théorique ci-dessus sont évités dans une troisième famille d'amplificateurs connus dans laquelle une autre disposition est mise en oeuvre et permet de manière effective d'éviter la sensibilité d'un amplificateur à la polarisation.

Le ruban des amplificateurs de cette troisième famille est constitué d'une manière homogène par un matériau actif massif dont la maille est identique à celle du matériau de base de sorte que ce matériau n'est pas contraint et est alors isotrope. Une insensibilité au moins approximative à la polarisation résulte du fait que la section de ce ruban est carrée ou sensiblement carrée c'est à dire que sa largeur par exemple 500nm, est égale ou peu supérieure à son épaisseur, par exemple 400nm. On rencontre alors les inconvénients déjà mentionnés tenant à une largeur trop petite du ruban, c'est à dire notamment une difficulté d'intégration de l'amplificateur avec d'autres composants optiques sur une même plaquette semi-conductrice. Cette troisième famille est notamment décrite dans un article : "1.55 μm Polarisation Independent Semiconductor Optical Amplifier with 25 dB Fiber to Fiber Gain" F. Doussière, F. Garabedian, C. Graver, D. Bonnevie, T. Fillion, E. Derouin, M. Monnot, J. G. Provost, D. Leclerc, Associate, IEEE, and M. Klenk.
IEEE PHOTONICS TECHNOLOGY LETTERS, VOL. 6, NO 2, FEBRUARY 1994.

Ces trois familles d'amplificateurs connus sont notamment mentionnées dans un compte rendu :
"High Performance MQW Laser Amplifiers for Transmission Systems Operating in the 1310 nm Window at Bitrates of 10Gbit/s and Beyond", L.F. Tiemeijer, Proc. 21st Eur. Conf. on Opt. Com. (ECOC'95-Brussels) P.259 et suivantes.

La présente invention vise à éviter les inconvénients mentionnés ci-dessus. Elle a pour but de permettre la réalisation d'un amplificateur optique à semiconducteur ayant autant que possible les qualités suivantes :

- facilité de réalisation et d'intégration,
- insensibilité à la polarisation,
- bonne position spectrale,
- bon rendement énergétique, et/ou
- forte puissance de sortie.

Dans ce but elle a pour objet un amplificateur optique à semi-conducteur à matériau actif homogène, une structure guidante de cet amplificateur procurant, pour la lumière à amplifier, un confinement horizontal selon la direction tranversale plus grand qu'un confinement vertical selon la direction de succession des couches semiconductrices de cet amplificateur. Cet amplificateur est caractérisé par le fait que son matériau actif est soumis à une contrainte de tension suffisante pour rendre le gain de cet amplificateur insensible à la polarisation de ladite lumière à amplifier. Cette contrainte résulte classiquement d'un désaccord de maille entre le matériau actif et le matériau de base. Typiquement ledit confinement horizontal est égal au produit dudit confinement vertical par un coefficient de dissymétrie de confinement supérieur à 1,02 et plus particulièrement à 1,05. La structure guidante peut être constituée par un ruban enterré ou érigé en saillie. Typiquement la largeur de ce ruban est comprise entre deux fois et vingt fois son épaisseur.

Cette invention résulte notamment du fait qu'il a été trouvé que, même en présence d'un coefficient de dissymétrie de confinement élevé résultant, par exemple, du fait que la structure guidante est constituée par un ruban à section fortement rectangulaire, la contrainte de tension à appliquer à un matériau actif homogène formant ce ruban pour obtenir l'insensibilité à la polarisation était suffisamment faible pour que l'épaisseur de ce ruban reste inférieure à l'épaisseur critique correspondante relative aux dislocations.

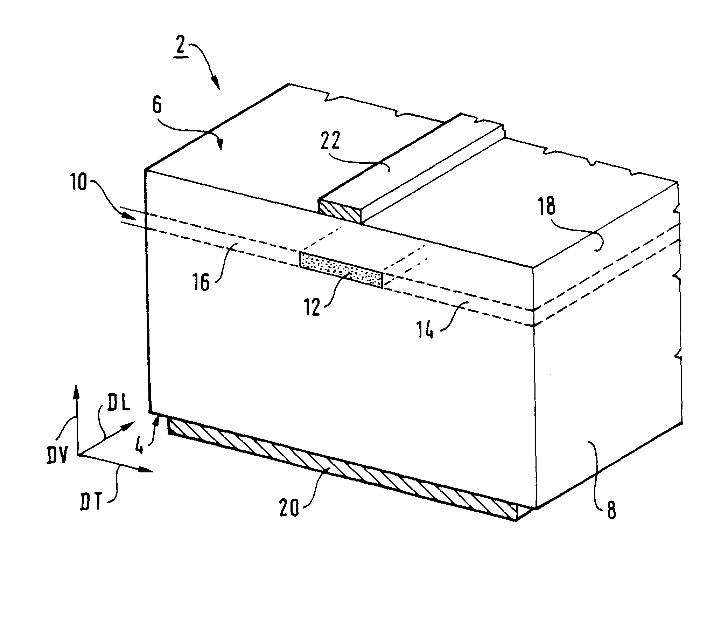

En se référant à la figure schématique unique ci-jointe on va indiquer ci-après, à simple titre d'exemple, comment cette invention peut être mise en oeuvre. Cette figure unique représente une vue en perspective d'un amplificateur à ruban enterré réalisé selon l'invention.

L'amplificateur donné en exemple comporte de manière connue une plaquette 2 constituée de couches de matériaux semi-conducteurs du type III-V ayant des indices de réfraction respectifs et formant un réseau cristallin commun. Des réseaux cristallins respectifs peuvent être formés par ces matériaux en l'absence de contraintes. Ils ont alors des dimensions caractéristiques constituant des mailles respectives de ces matériaux. Ces couches se succèdent selon une direction verticale DV formant un trièdre trirectangle avec deux directions horizontales constituant une direction longitudinale DL et une direction transversale DT Ces directions sont bien entendu définies par rapport à cet amplificateur. Ces couches forment une succession dans un sens ascendant de ladite direction verticale d'une face inférieure 4 à une face supérieure 6 de la plaquette. Cette succession inclut au moins les couches ou groupe ou partie de couches suivants:

- Un substrat 8 constitué majoritairement d'un matériau de base semi-conducteur à deux composants ayant un premier type de conductivité, ce substrat présentant une épaisseur suffisante pour imposer les dimensions de la maille de ce matériau de base audit réseau cristallin commun.

- Une couche active 10 incluant ledit ruban 12 entre deux bandes latérales 14 et 16. Ce ruban est constitué de manière homogène par un matériau actif à au moins trois composants. Ce matériau est dit actif parce qu'il est apte à amplifier une lumière par recombinaison stimulée de porteurs de charges des deux types injectés dans ce matériau. Les dimensions horizontales de sa maille sont inférieures à celles de la maille du matériau de base. Elles présentent par rapport à ce matériau de base un écart relatif de maille typiquement compris entre -0,05 % et -0,20 % et de préférence entre -0,12% et -0,18% pour que le substrat applique à cette couche une contrainte de tension. Ce ruban présente un indice de réfraction plus grand que celui des matériaux environnants et s'étend selon la direction longitudinale pour guider la lumière selon cette direction. Il présente une largeur et une épaisseur respectivement transversale et verticale. Cette largeur est de préférence comprise entre deux fois et vingt fois cette épaisseur. Elle est typiquement supérieure à 500nm et avantageusement comprise entre 800 et 2000nm pour faciliter la formation du ruban par gravure d'une couche complète du matériau actif. Cette épaisseur est typiquement comprise entre 100 et 400nm environ pour assurer un guidage mononodal de la lumière.

Cette succession comporte enfin une couche de confinement supérieure 18 constituée d'un matériau ayant un deuxième type de conductivité opposé au premier.

L'amplificateur comporte en outre une électrode inférieure 20 et une électrode supérieure 22 respectivement formées sur la face inférieure et sur la face supérieure de la plaquette pour permettre de faire passer entre ces deux faces un courant électrique. C'est ce courant qui injecte lesdits porteurs de charges des deux types dans le ruban à partir du substrat et de la couche de confinement supérieure.

Dans un cas particulier la longueur d'onde de fonctionnement de l'amplificateur est 1550 nm. Le matériau de base est le phosphure d'indium InP, le substrat est de type n, le matériau actif est un matériau quaternaire

$$In_{1-x} Ga_x P_{1-y} As_y,$$

les paramètres x et y valant respectivement 0,45 et 0,93 de manière que l'écart relatif de maille vaille -0,15%. La couche de confinement supérieure est constituée de phosphure d'indium de type p. La largeur et l'épaisseur de ruban sont respectivement 1000 et 400nm. De nombreuses autres dispositions de cet amplificateur sont classiques ou à la portée du spécialiste.

Dans le cas d'un amplificateur à ruban érigé en saillie l'écart relatif de maille du matériau actif par rapport au matériau de base est typiquement compris entre les deux valeurs précédemment indiquées dans le cas du ruban enterré.

## Revendications

1. Amplificateur optique à semi-conducteur à matériau actif homogène, une structure guidante de cet amplificateur procurant, pour une lumière à amplifier, un confinement horizontal (CH) selon la direction tranversale (DT) plus grand qu'un confinement vertical (CV) selon la direction (DV) de succession des couches semiconductrices, cet amplificateur étant caractérisé par le fait que ledit matériau actif (12) est soumis à une contrainte de tension suffisante pour rendre le gain de cet amplificateur insensible à la polarisation de ladite lumière à amplifier.

2. Amplificateur selon la revendication 1, cet amplificateur étant caractérisé par le fait que ledit confinement horizontal (CH) est égal au produit dudit confinement vertical (CV) par un coefficient de dissymétrie de confinement supérieur à 1,02.

3. Amplificateur selon la revendication 2, ledit coefficient de dissymétrie de confinement étant supérieur à 1,05.

4. Amplificateur selon la revendication 1, ladite structure guidante présentant la forme d'un ruban (12) présentant une largeur comprise entre deux fois et vingt fois son épaisseur et supérieure à 500nm, ce ruban constituant ledit matériau actif.

5. Amplificateur selon la revendication 1, ledit matériau actif ayant au moins trois composants appartenant aux deux colonnes III et V du tableau périodique des éléments, le dit ruban étant formé dans une plaquette semi-conductrice (2) constituée majoritairement d'un matériau de base ayant deux composants appartenant respectivement à ces deux colonnes.

6. Amplificateur selon la revendication 5, le dit matériau actif présentant par rapport audit matériau de base un écart relatif de maille compris entre -0,05% et -0,20% pour que ladite plaquette applique ladite contrainte de tension à ce ruban.

7. Amplificateur selon la revendication 1 comportant une plaquette (2) constituée de couches de matériaux semi-conducteurs du type III-V ayant des indices de réfraction respectifs et formant un réseau cristallin commun, des réseaux cristallins respectifs pouvant être formés par ces matériaux en l'absence de contraintes et ayant alors des dimensions caractéristiques constituant des mailles respectives de ces matériaux, ces couches se succédant selon une direction verticale (DV) formant un trièdre trirectangle avec deux directions horizontales constituant une direction longitudinale (DL) et une direction transversale (DT), ces directions étant définies par rapport à cette plaquette, ces couches formant une succession dans un sens ascendant de ladite direction verticale d'une face inférieure (4) à une face supérieure (6) de ladite plaquette, cette succession constituant au moins :

- un substrat (8) constitué majoritairement d'un matériau de base semi-conducteur à deux composants ayant un premier type de conductivité, ce substrat présentant une épaisseur suffisante pour imposer les dimensions de la maille de ce matériau de base audit réseau cristallin commun,

- une couche active (10) incluant ledit ruban (12) entre deux bandes latérales (14 et 16), ce ruban étant constitué par un matériau actif à au moins trois composants apte à amplifier une lumière par recombinaison stimulée de porteurs de charges des deux types injectés dans ce matériau, les dimensions horizontales de la maille de ce matériau actif étant inférieures à celles de la maille du matériau de base, ce ruban présentant un indice de réfraction plus grand que celui des matériaux environnants et s'étendant selon ladite direction longitudinale pour guider ladite lumière selon cette direction, ce ruban présentant une largeur et une épaisseur respectivement transversale et verticale, cette largeur étant comprise entre deux fois et vingt fois cette épaisseur,

- et une couche de confinement supérieure (18) constituée d'un matériau ayant un deuxième type de conductivité opposé au premier,

cet amplificateur comportant en outre une électrode inférieure (20) et une électrode supérieure (22) respectivement formées sur ladite face inférieure et sur ladite face supérieure de la plaquette pour permettre de faire passer entre ces deux faces un courant électrique injectant lesdits porteurs de charges des deux types dans ledit ruban à partir dudit substrat et de ladite couche de confinement supérieure.

8. Amplificateur selon la revendication 7, la largeur dudit ruban étant comprise entre 800 et 2000nm, son épaisseur étant comprise entre 100 et 400nm environ.

**Patentansprüche**

1. Optischer Halbleiterverstärker mit homogenem aktivem Material, wobei eine Führungsstruktur dieses Verstärkers für ein zu verstärkendes Licht eine horizontale Einschließung (CH) in Querrichtung (DT) bewirkt, die größer als eine vertikale Einschließung (CV) in Richtung (DV) der Abfolge der Halbleiterschichten ist, dadurch gekennzeichnet, daß das aktive Material (12) einer ausreichenden Spannungsbelastung ausgesetzt ist, um die Verstärkung dieses Verstärkers für die Polarisation des zu verstärkenden Lichtes unempfindlich zu machen.

**2.** Verstärker nach Anspruch 1, dadurch gekennzeichnet, daß die horizontale Einschließung (CH) gleich dem Produkt der vertikalen Einschließung (CV) mit einem Einschließungs-Asymmetriekoeffizienten von mehr als 1,02 ist.

**3.** Verstärker nach Anspruch 2, bei dem der Einschließungs-Asymmetriekoeffizient größer als 1,05 ist.

**4.** Verstärker nach Anspruch 1, bei dem die Führungsstruktur die Form eines Bandes (12) hat, das eine Breite zwischen dem Zweifachen und dem Zwanzigfachen seiner Dicke und von mehr als 500 nm aufweist, wobei dieses Band das aktive Material bildet.

**5.** Verstärker nach Anspruch 1, bei dem das aktive Material wenigstens drei Komponenten aufweist, die zu den zwei Spalten III und V des Periodensystems der Elemente gehören, wobei das Band in einer Halbleiterplatte (2) gebildet ist, die mehrheitlich aus einem Basismaterial besteht, das zwei zu diesen zwei Spalten gehörende Komponenten hat.

**6.** Verstärker nach Anspruch 5, bei dem das aktive Material im Verhältnis zum Basismaterial eine relative Abweichung der Zellengröße zwischen -0,05 % und -0,20 % aufweist, so daß die Platte die Spannungsbelastung auf das Band ausübt.

**7.** Verstärker nach Anspruch 1 mit einer Platte (2), die aus Schichten von Halbleitermaterialien vom Typ III-V gebildet ist, die jeweils Brechungsindizes aufweisen und ein gemeinsames Kristallgitter bilden, wobei die jeweiligen Kristallgitter durch diese Materialien in Abwesenheit von Belastungen gebildet sein können und dann charakteristische Abmessungen haben, die jeweils Zellen dieser Materialien bilden, wobei diese Schichten in einer vertikalen Richtung (DV) aufeinanderfolgen, die einen 3-fach rechteckigen Trieder mit zwei horizontalen Richtungen bildet, die eine Längsrichtung (DL) und eine Querrichtung (DT) bilden, wobei diese Richtungen in Bezug auf diese Platte definiert sind, diese Schichten eine Folge in Aufwärtsorientierung der vertikalen Richtung von einer Unterseite (4) zu einer Oberseite (6) der Platte bilden, wobei diese Folge wenigstens bildet:

- ein Substrat (8), das mehrheitlich aus einem Halbleiter-Basismaterial mit zwei Komponenten gebildet ist, das einen ersten Leitfähigkeitstyp hat, wobei dieses Substrat eine ausreichende Dicke aufweist, um die Abmessungen der Zelle dieses Basismaterials dem gemeinsamen Kristallgitter vorzugeben,
- eine aktive Schicht (10), die das Band (12) zwischen zwei seitlichen Streifen (14 und 16) einschließt, wobei dieses Band durch ein aktives Material mit wenigstens drei Komponenten gebildet ist, das in der Lage ist, Licht durch stimulierte Rekombination von in dieses Material eingespeisten Ladungsträgern der zwei Typen zu verstärken, wobei die horizontalen Abmessungen der Zelle dieses aktiven Materials kleiner als die der Zelle des Basismaterials sind, wobei das Band einen größeren Brechungsindex als den der umgebenden Materialien aufweist und sich in die Längsrichtung erstreckt, um das Licht in dieser Richtung zu führen, wobei dieses Band eine Breite und eine Dicke in Querrichtung bzw. vertikaler Richtung aufweist und diese Breite zwischen dem Zweifachen und dem Zwanzigfachen dieser Dicke liegt,
- und eine obere Einschließungsschicht (18), die aus einem Material mit einem zweiten, dem ersten entgegengesetzten Leitfähigkeitstyp gebildet ist,

wobei dieser Verstärker ferner eine untere Elektrode (20) und eine obere Elektrode (22) umfaßt, die jeweils auf der Unterseite bzw. der Oberseite der Platte gebildet sind, um einen elektrischen Strom zwischen diesen zwei Seiten fließen lassen zu können, der die Ladungsträger der zwei Typen in das Band vom Substrat und der oberen Einschließungsschicht aus einspeist.

**8.** Verstärker nach Anspruch 7, bei dem die Breite des Bandes zwischen 800 und 2000 nm beträgt und seine Dicke zwischen ca. 100 und 400 nm beträgt.

**Claims**

**1.** Homogeneous active material semiconductor optical amplifier, a guide structure of said amplifier procuring, for light to be amplified, a horizontal confinement (CH) in the transverse direction (DT) greater than a vertical confinement (CV) in the direction (DV) of succession of the semiconductor layers, this amplifier being characterised in that said active material (12) is subjected to a tensile strain sufficient to render the gain of this amplifier insensitive to the polarisation of said light to be amplified.

**2.** Amplifier according to claim 1 characterised in that said horizontal confinement (CH) is equal to the product of said vertical confinement (CV) by a confinement asymmetry coefficient greater than 1.02.

**3.** Amplifier according to claim 2, said confinement asymmetry coefficient being greater than 1.05.

**4.** Amplifier according to claim 1, said guide structure having the form of a stripe (12) having a width between twice and twenty times its thickness and greater than 500 nm, this stripe constituting said active material.

5. Amplifier according to claim 1, said active material having at least three components from columns III and V of the periodic table of the elements, said stripe being formed in a semiconductor wafer (2) consisting mainly of a base material having two components respectively belonging to these two columns.

6. Amplifier according to claim 5, said active material having relative to said base material a relative lattice constant difference between -0.05% and -0.20% so that said wafer applies said tensile strain to said stripe.

7. Amplifier according to claim 1 including a wafer (2) constituted of layers of III-V type semiconductor materials having respective refractive indices and forming a common crystal lattice, these materials forming respective crystal lattices in the absence of strains and then having characteristic dimensions constituting a respective lattice constant of these materials, these layers being in succession in a vertical direction (DV) forming a right-angle trihedron with two horizontal directions constituting a longitudinal direction (DL) and a transverse direction (DT), these directions being defined relative to this wafer, these layers forming a succession in a vertically upwards direction from a bottom face (4) to a top face (6) of said wafer, said succession constituting at least:

- a substrate (8) consisting mainly of a two-component semiconductor base material having a first type of conductivity, this substrate having a thickness sufficient to impose the lattice constant of this base material on said common crystal lattice,
- an active layer (10) including said stripe (12) between two lateral bands (14 and 16), this stripe being constituted of an active material with at least three components able to amplify light by stimulated recombination of charge carriers of both types injected into this material, the horizontal dimensions of the lattice constant of this active material being less than those of the lattice constant of the base material, this stripe having a refractive index higher than that of the surrounding materials and extending in said longitudinal direction to guide said light in this direction, this stripe having a transverse width and a vertical thickness, this width being between twice and twenty times this thickness, and
- a top confinement layer (18) consisting of a material having a second type of conductivity opposite the first,

this amplifier further including a bottom electrode (20) and a top electrode (22) respectively formed on said bottom face and on said top face of the wafer to enable an electric current to be passed between these two faces to inject said charge carriers of both types into said stripe from said substrate and from said top confinement layer.

8. Amplifier according to claim 7, the width of said stripe being between 800 nm and 2 000 nm, its thickness being between about 100 nm and 400 nm.